## Europäisches Patentamt
## European Patent Office
## Office européen des brevets

(19)

(11) Veröffentlichungsnummer: **0 045 926**
**B1**

,(12)                    EUROPÄISCHE PATENTSCHRIFT

(45) Veröffentlichungstag der Patentschrift: 03.12.86

(51) Int. Cl.⁴: **H 05 K 7/18**

(21) Anmeldenummer: 81106069.8

(22) Anmeldetag: 03.08.81

(54) Gehäuse für elektrotechnische Geräte, insbesondere für die elektrotechnische Nachrichtentechnik.

(30) Priorität: 08.08.80 DE 3030162

(43) Veröffentlichungstag der Anmeldung:
17.02.82 Patentblatt 82/07

(45) Bekanntmachung des Hinweises auf die
Patenterteilung:
03.12.86 Patentblatt 86/49

(84) Benannte Vertragsstaaten:
AT BE CH FR GB IT LI LU NL SE

(56) Entgegenhaltungen:
AT-B- 174 097
DE-A-2 147 843
DE-A-2 459 676
DE-A-2 732 139
DE-B-1 591 460
DE-B-2 523 689
US-A-3 904 937

(73) Patentinhaber: **Siemens Aktiengesellschaft**
**Berlin und München**
**Wittelsbacherplatz 2**
**D-8000 München 2 (DE)**

(72) Erfinder: **Riedl, Friedrich**
**Herbststrasse 15**
**D-8035 Gauting (DE)**
Erfinder: **Weissgerber, Wilhelm**
**Birkenstrasse 21**
**D-8039 Puchheim (DE)**

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

**Beschreibung**

Die Erfindung bezieht sich auf ein Gehäuse für elektrotechnische Geräte, insbesondere für die elektrische Nachrichtentechnik, mit einem Rahmen aus stranggepreßten Profilschienen, welche für die Befestigung von Innenaufbauten, Abdeckungen und Außenwänden an jeder Seite mit einer zur Schienenaußenseite hin offenen, symmetrisch in Bezug auf die Schienenlängsachse angeordneten zentralen Nut zur Aufnahme von Gleitmuttern sowie an einer ersten Seite mit zwei symmetrisch in Bezug auf die Öffnung der zentralen Nut angeordneten weiteren, zur Schienenaußenseite hin offenen, rechteckförmigen Nuten und an zwei gegenüberliegenden und zu der ersten Seite senkrechten Seiten neben der zentralen Nut mit jeweils einer weiteren, zur Schienenaußenseite hin offenen, rechteckförmigen Nut ausgebildet sind und die an den Rahmenecken über würfelförmige, jeweils in Richtung der Längsachse der drei zu verbindenden Profilschienen mit Durchbrechungen für in Bohrungen in der Längsachse der Profil-schienen eingreifende Schrauben versehene Eck-bausteine miteinander verbunden sind, die mit dem Profil der rechteckförmigen Nuten angepaßten Ausnehmungen ausgebildet sind, in welche eine Dichtschnur von einer Profilschiene über den Eckbaustein zu einer anderen Porfilschiene einlegbar ist.

Durch die DE—OS—24 59 676 ist ein Schrank zur Aufnahme von Baugruppen bekannt, dessen Grundaufbau aus einem aus Metallprofilen zusammengesetzten Gerüst besteht. Dabei besteht das Metallprofil im Kern aus einem rechtwinkligen Vierkantprofil, dem an allen vier Seiten nach außen je ein C-Profil aufgesetzt ist, das erste Nuten zur Aufnahme von Klemmkörpern bildet. Außerdem sind seitlich der C-Profile noch nach außen offen zweite Nuten zur Aufnahme von Schiebeblenden vorgesehen. Für die Eckverbindungen der Metallprofile sind hohle Eckwürfel vorgesehen, die eine kreuzförmige Montageöffnung, zentrale Bohrungen und kantenparallele Nuten sowie an der diesen Nuten gegenüberlie-genden Würfelhälfte Aussparungen in den Kanten aufweisen, die mit wenigstens einem Teil der Nuten der angrenzenden Metallprofile fluchten. Hierbei sind die Aussparungen in den Kanten als schachtförmige, sich in das Innere des hohlen Eckwürfels erstreckende Vertiefungen ausgebildet, die ein ganz spezielles Profil für die Eckwürfel erforderlich machen. Außerdem ist bei der bekannten Einrichtung nicht an allen Verbindungsstellen zwischen Metallprofilen und Eckwürfeln eine Dichtungsmöglichkeit vorgesehen.

Der Erfindung liegt die Aufgabe zugrunde, bei einem Gehäuse der eingangs genannten Art mit an allen Seiten der Profilschienen gegebenen Befestigungsmöglichkeiten für Innen- und Außenaufbauten die Profilschienen sowie die Eckbausteine auf möglichst einfache Weise so auszubilden, daß an allen Verbindungsstellen zwischen Profilschienen und Eckbausteinen eine gute Dichtung gegen Wasser und Hochfrequenzfelder erzielbar ist.

Diese Aufgabe wird bei einem Gehäuse der eingangs genannten Art gemäß der Erfindung dadurch gelöst, daß die zentrale Nut als Kreuznut ausgebildet ist, und daß die Ausnehmungen an den drei gegen die zu verbindenden Profilschienen gerichteten Ecken eines Eckbausteines vorgesehen sind, wobei jede Ausnehmung durch die Entfernung jeweils einer geeigneten Ecke einer Außenfläche des würfelförmigen Eckbausteines gebildet ist.

Auf diese Weise ist an allen Verbindungsstellen zwischen Profilschienen und Eckbausteinen eine gute Dichtung erzielbar, wobei für die Eckbausteine kein spezielles Profil erforderlich ist, da die Ausnehmungen für eine umlaufende Dichtungsnut durch Entfernung entsprechender Ecken des würfelförmigen Eckbausteines gebildet sind.

Nachstehend wird die Erfindung anhand von Figuren näher erläutert.

Es zeigen
Fig. 1 das Profil der Schienen selbst,
Fig. 2 eine Rahmeneckverbindung unter drei Schienen,
Fig. 3 einen Eckbaustein und dessen Herstellungsmöglichkeit und
Fig. 4 eine andere Art der Herstellung eines Eckbausteines.

Das Profil der Schiene 1 hat Ähnlichkeit mit vier symmetrish angeordneten C's, die mittig anein-ander liegen. Symmetrisch angeordnet hinsicht-lich der Längsachse mit einer Bohrung 8 sind Kreuznuten 3. Diese Kreuznuten 3 sind auf der Außenseite offen. In die Kreuznuten können Gleitmuttern 6 eingelegt werden. Die Gleitmuttern sind zweckmäßig gemäß dem deutschen Patent 2 147 843 ausgebildet, nämlich mit einer sie umgebenden Blattfeder 7 versehen, die auf einer Seite offen ist, damit sie in die Nut federn kann und die Mutter 6 dadurch gegen Gleiten, d.h. Verrutschen, innerhalb der Nut gesichert ist. Dies ist besonders nützlich zur Befestigung von Innen- und Außenaufbauten, da die Lage der Muttern mit den Bohrungen in den Verkleidungsblechen übereinstimmen muß.

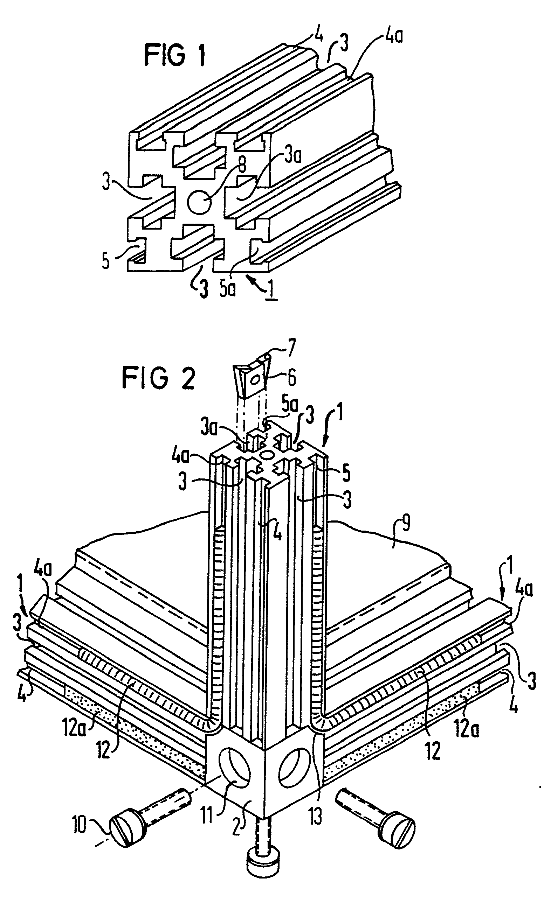

Wie besonders Fig. 1 erkennen läßt, ist die Profilschiene 1 in einer ersten Seite symmetrisch zur der Öffnung einer solchen Kreuznut 3 mit jeweils einer rechteckförmigen Nut 4 bzw. 4a ausgebildet. In diese Nuten kann eine Dichtschnur 12 bzw. 12a eingelegt werden. Solche Dichtschnüre, die gegen Wasser und gleichzeitig Hochfrequenzfelder abdichten, sind hinlänglich bekannt. Zur besseren Halterung der Dichtschnur ist die Breite der Öffnung der rechteckförmigen Nuten 4,4a etwas geringer als die Nutbreite.

Außerdem ist die Profilschiene 1 in zwei gegenüberliegenden und zu der ersten Seite senkrechten Seiten neben der Kreuznut 3 bzw. 3a mit jeweils einer weiteren, zur Schienenaußenseite hin offenen, rechteckför-

migen Nut 5 bzw. 5a ausgebildet. Hierbei ist die Breite der Öffnung der Nuten 5,5a ebenfalls etwas geringer als die Nutbreite. Wie aus Fig. 2 gut ersichtlich, läßt sich hierdurch eine Dichtheit auf allen drei Seiten eines Ecks erreichen.

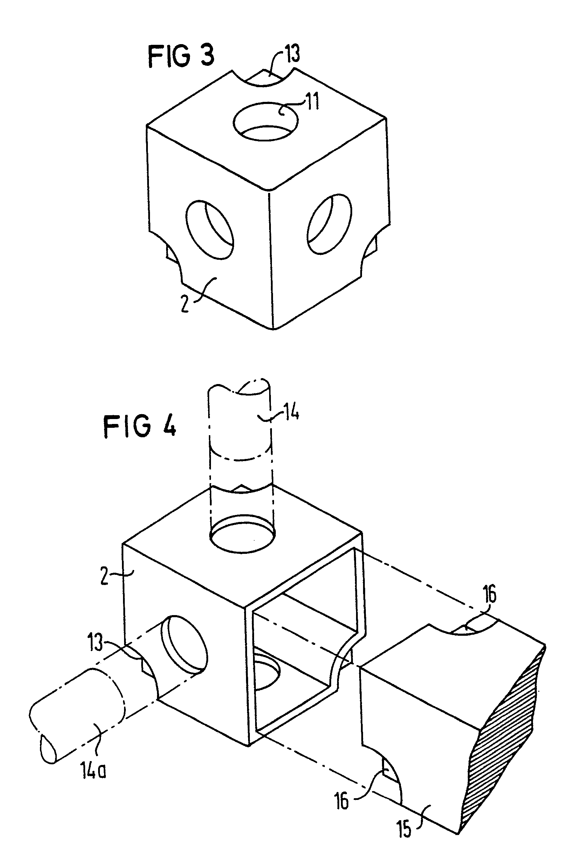

Zur Verbindung der Profilschienen 1 an den Ecken sind würfelförmige Eckbausteine 2 vorgesehen. Diesen haben auf den jeweils drei außen liegenden Seiten jeweils in Richtung der Längsachse der drei zu verbindenden Profilschienen Bohrungen 11, durch die Schrauben 10 hindurchgeführt werden können. Die Bohrungen 11 sind auf der der Außenseite eines Eckbausteines genenüberliegenden Seite mit kleinerem Durchmesser fortgesetzt, so daß wohl der Schraubenschaft durch sie in die Bohrung 8 jeweils einer Profilschiene hindurchgeführt werden kann, jedoch nicht der Schraubenkopf. An der Außenseite eines Eckbausteins sind die Bohrungen 11 dagegen mit solchem Durchmesser ausgeführt, daß auch der Schraubenkopf versenkbar im Eckbaustein verschwindet. Um auch die Dichtschnüre 12 ohne Unterbrechung über einen Eckbaustein führen zu können, sind die Eckbausteine an den drei gegen die zu verbindenden Profilschienen gerichteten Ecken mit kreisbogenförmigen Ausfräsungen 13 vorgesehen. Besonders gut ist dies aus Fig. 3 erkennbar, die eine Ausführungsmöglichkeit für einen Eckbaustein zeigt. Die Herstellung des Eckbausteines geschieht hier durch Fräsen und Bohren aus Vollmetall. Ein anderes Verfahren für die Herstellung eines Eckbausteines zeigt die Fig. 4 für Spritzguß. Dabei greift ein Stempel 15 mit Ausnehmungen 16 zur Herstellung der Ausnehmungen 13 des Eckbausteines in eine Form für den Eckbaustein 2 ein. Zusätzliche Stempel, die durch 14 und 14a angedeutet sind und die bis auf die Oberfläche des Stempels reichen, sorgen für die Herstellung der Druchbrüche 11. Der Eckbaustein kann so auf einfache Weise als leichtes Hohlprofil hergestellt werden.

Die Befestigung der Innen- und Außenaufbauten kann—wie erwähnt—über die Gleitmuttern 6 erfolgen. Besonders einfach ist die Aufbringung von Außenwänden, das diese direkt aufgeschraubt werden können und als ebene Bleche ausführbar sind. Wie bei Fig. 2 dargestellt, können auch Bleche 9 versenkt angeordnet werden, das heißt mit besonderen Prägungen, die nur im Randbereich auf den Profilschienen 1 aufliegen. In jedem Fall sorgen Dichtschnüre 12 und gegebenenfalls zusätzliche Hochfrequenz - Dichtschnüre 12a in der zweiten äußeren Nut 4 für eine gute Dichtung gegen Wasser und Hochfrequenzfelder.

Die Bohrungen 8 der Profilschienen können insbesondere bei stranggepreßtem Profil durchgehend und glattwandig ausgeführt sein. Die Verbindungsschrauben 10 müssen dann selbstschneidende Schrauben sein. Man kann aber auch in glattwandigen Bohrungen vorher Gewinde einschneiden und normale Schrauben verwenden. Natürlich können die Bohrungen 8 auch als Sachlöcher ausgeführt sein.

**Patentansprüche**

1. Gehäuse für elektrotechnische Geräte, insbesondere für die elektrische Nachrichtentechnik, mit einem Rahmen aus stranggepreßten Profilschienen (1), welche für die Befestigung von Innenaufbauten, Abdeckungen und Außenwänden an jeder Seite mit einer zur Schienenaußseite hin offenen, symmetrisch in Bezug auf die Schienenlängsachse angordneten zentralen Nut (3,3a) zur Aufnahme von Gleitmuttern (6) sowie an einer ersten Seite mit zwei symmetrisch in Bezug auf die Öffnung der zentralen Nut angeordneten weiteren zur Schienenaußenseite hin offenen, rechteckförmigen Nuten (4,4a) und an zwei gegenüberliegenden und zu der ersten Seite senkrechten Seiten neben der Zentralen Nut mit jeweils einer weiteren, zur Schienenaußenseite hin offenen, rechteckförmigen Nut (5,5a) ausgebildet sind und die an den Rahmenecken über würfelförmige, jeweils in Richtung der Längsachse der drei zu verbindenden. Profilschienen mit Durchbrechungen (11) für in Bohrungen (8) in der Längsachse der Profilschienen eingreifende Schrauben (10) versehene Eckbausteine (2) miteinander verbunden sind, die mit dem Profil der rechteckförmigen Nuten (4,4a bzw. 5,5a) angepaßten Ausnehmungen (13) ausgebildet sind, in welche eine Dichtschnur (12) von einer Profilschiene (1) über den Eckbaustein (2) zu einer anderen Profilschiene (1) einlegbar ist, dadurch gekennzeichnet, daß die zentrale Nut (3,3a) als Kreuznut ausgebildet ist, und daß die Ausnehmungen (13) an den drei gegen die zu verbindenden Profilschienen (1) gerichteten Ecken eines Eckbausteines (2) vorgesehen sind, wobei jede Ausnehmung (13) durch die Entfernung jeweils einer geeigneten Ecke einer Außenfläche des würfelförmigen Eckbausteines (2) gebildet ist.

2. Gehäuse nach Anspruch 1, dadurch gekennzeichnet, daß die Ausnehmungen (13) an den Ecken der Eckbausteine (2) durch kreisbogenförmige Ausfräsungen gebildet sind.

**Revendications**

1. Boîtier pour des appareils électrotechniques, en particulier pour la technique électrique de communication, comportant un cadre constitué par des rails profilés (1), obtenus par extrusion, qui sont conformés de manière à présenter, pour la fixation d'équipements intérieurs, de couvercles et de parois extérieures, sur chaque côté, une gorge centrale (3, 3a) ouverte du côté extérieur du rail et disposée symétriquement par rapport à l'axe longitudinal du rail pour recevoir des écrous coulissants (8), ainsi que sur un premier côté, deux autres gorges (4, 4a) de forme rectangulaire, ouvertes du côté extérieur du rail et symétriques par rapport à l'ouverture de la gorge centrale, et sur chacun des deux côtés opposés et perpendiculaires au premier côté, près de la gorge central, et ouverte du côté extérieur du rail, une gorge rectangulaire (5, 5a), lesdits rails profilés étant réunis entre eux au niveau des sommets du cadre à l'aide d'éléments sommitaux (2) en forme de dés, dont chacun est pourvu, en direction de l'axe longitudinal des trois rails profilés à réunir, d'ouvertures (11) pour des vis (10) pénétrant dans des perçages (8) ménagés dans l'axe longitudinal des rails profilés, alors que lesdits éléments sommitaux (2) sont pourvus de dégagements (13) adaptés au profil des gorges de forme rectangulaire (4, 4a; 5, 5a) et dans lesquelles un cordon d'étanchéité (12) est susceptible d'être mis en place d'un rail profilé (1) à un autre rail profilé (1), en passant par un élément sommital (12), caractérisé par le fait que la gorge centrale (3, 3a) est réalisée sous la forme d'une gorge cruciforme et que les dégagements (13) sont ménagés au niveau de trois sommets d'une pièce sommitale (2), dirigés vers les rails profilés (1) à relier, chaque dégagement (13) étant formé par suppression d'un sommet approprié d'une surface extérieure de la pièce sommitale (2) en forme de dé.

2. Boîtier selon la revendication 1, caractérisé par le fait que les dégagements (13) au niveau des sommets de piéces sommitales (2) sont réalisés par des fraisages en forme d'arc-de-cercle.

### Claims

1. A housing for electrotechnical apparatus, in particular for electrical communications engineering, comprising a frame of extruded profiled bars (1) which, for securing internal structures, covers and external walls, are provided on each side with a central groove (3, 3a) which is open towards the outside of the bars, is symmetrically arranged in relation to the longitudinal axis of the bars and serves to house sliding nuts (6), and which profile bars on a first side are provided with two further rectangular grooves (4, 4a) which are open towards the outside of the bars and are symmetrically arranged in relation to the opening of the central groove, and on two opposite sides, which are at right angles to the first side, in addition to the central groove, are in each case provided with a further rectangular groove (5, 5a) which is open towards the outside of the bars, and at the frame corners, are connected to one another by means of cubic corner members (2) which in the direction of the longitudinal axis of the three profile bars to be connected are in each case provided with openings (11) for screws (10) which engage into bores (8) in the longitudinal axes of the profile bars, and which corner members have recesses (13) which are matched to the profile of the rectangular grooves (4, 4a and 5, 5a) and into which a sealing cord (12) can be inserted from one profile bar (1) to another profile bar (1) through the corner member (2), characterised in that the central groove (3, 3a) is designed as a cross-shaped groove, and that the recesses (13) are arranged at the three corners of a corner member (2) which face towards the profile bars (1) to be connected, each recess (13) being formed by the spacing in each case of an appropriate corner of an outer surface of the cubical corner member (2).

2. A housing as claimed in Claim 1, characterised in that the recesses (13) are formed by circular notches at the corners of the corner members (2).

0 045 926

FIG 1

FIG 2

1

# FIG 3

13

11

2

# FIG 4

14

2

13

16

14a

16

15